# FASCICULE DE BREVET EUROPEEN

(11) **EP 3 142 152 B1**
(45) Date de publication et mention de la délivrance du brevet: **20.02.2019**
(21) Numéro de dépôt: 16188202.2
(22) Date de dépôt: 09.09.2016
(51) Int. Cl.: H01L 29/66, H01L 21/02, H01L 21/265, H01L 21/266, H01L 29/10, H01L 21/84, H01L 21/8234, H01L 29/786, H01L 29/165, H01L 29/78

(54) **PROCEDE DE MISE EN TENSION D'UN FILM SEMI-CONDUCTEUR**
VERFAHREN ZUM VERSPANNEN EINER HALBLEITERSCHICHT
METHOD FOR TENSIONING A SEMICONDUCTOR FILM

(30) Priorité: 11.09.2015 FR 1558482
(43) Date de publication de la demande: 15.03.2017
(73) Titulaire: Commissariat à l'énergie atomique et aux énergies alternatives, 75015 Paris (FR); STMicroelectronics (Crolles 2) SAS, 38920 Crolles (FR)
(72) Inventeur: AUGENDRE, Emmanuel, 38330 MONTBONNOT (FR); HALIMAOUI, Aomar, 38660 La Terrasse (FR); MAITREJEAN, Sylvain, 38000 GRENOBLE (FR); REBOH, Shay, 38054 GRENOBLE (FR)
(74) Mandataire: Brevalex

(56) Documents cités:
- EP-A1- 2 782 118
- EP-A2- 2 840 594
- WO-A1-2007/064472
- US-A1- 2005 124 146
- US-A1- 2009 298 301

## Description

### DOMAINE TECHNIQUE ET ART ANTÉRIEUR

La présente demande concerne le domaine des structures comprenant une couche semi-conductrice ayant une déformation ou une contrainte mécanique.

Par déformation mécanique on entend un matériau qui a son ou ses paramètre(s) de maille cristalline allongé(s) ou écourté(s) par rapport à un paramètre de maille nominal.

Dans le cas où le paramètre de maille déformé est plus important que le paramètre dit « naturel » du matériau cristallin, celui-ci est dit en déformation tensive ou en tension. Lorsque le paramètre de maille déformé est plus petit que le paramètre de maille naturel, le matériau est dit en déformation compressive ou en compression.

A ces états de déformation mécanique, on associe des états de contraintes mécaniques. Pour autant, il est également commun de se référer à ces états de déformation comme des états de contraintes mécaniques. Dans la suite de la présente demande, cette notion de déformation (« strain » selon la terminologie anglo-saxonne) sera désignée de façon générique par le terme « contrainte ».

Pour certaines applications, en particulier pour la réalisation de transistors, il peut être avantageux de prévoir une couche de matériau semi-conducteur contraint. Une contrainte mécanique en tension ou en compression sur une couche semi-conductrice permet en effet d'induire une augmentation de la vitesse des porteurs de charge. On améliore ainsi les performances de dispositifs à transistors formés dans une telle couche.

Il est connu de réaliser des substrats de type semi-conducteur contraint sur isolant, c'est-à-dire dans lesquels le matériau de la couche superficielle semi-conductrice est contrainte, cette couche superficielle étant disposée sur une couche isolante, elle-même disposée sur une couche de support généralement semi-conductrice.

La couche superficielle semi-conductrice contrainte est généralement destinée à servir de couche active c'est-à-dire dans laquelle au moins une partie de composants électroniques tels que des transistors est destinée à être formée.

On sait en particulier réaliser des substrats de type sSOI (sSOI pour « strained Silicon On Insulator » ou silicium contraint sur isolant) comportant une couche superficielle de silicium contraint en tension.

Une méthode pour réaliser un tel type de substrat peut consister tout d'abord à faire croitre par épitaxie une couche semi-conductrice à base SiGe contraint en compression sur une couche semi-conductrice à base Si. Puis, on réalise une implantation ionique de la couche de Si et d'une région inférieure de la couche de SiGe de sorte à relaxer le SiGe. On effectue ensuite une recristallisation de la région inférieure de la couche de SiGe et de la couche de Si en se servant d'une région supérieure de la couche de SiGe qui n'a pas été rendue amorphe et dont la structure cristalline a été conservée comme zone de départ à un front de recristallisation. Pendant la recristallisation, les germes de SiGe cristallin imposent leur paramètre de maille à la couche de Si qui est alors mise en tension.

Lors de l'amorphisation du SiGe qui conduit à sa relaxation, un phénomène de fluage de la région rendue amorphe peut apparaitre. Cela a tendance à créer des discontinuités dans la région supérieure de la couche de SiGe non-amorphisée et dont la structure cristalline a été conservée. Cette région supérieure est alors formée d'ilots cristallins répartis de manière aléatoire. Lorsqu'on effectue la recristallisation, un phénomène de rotation des ilots peut donner naissance à des discontinuités d'orientation cristalline dans les couches recristallisées. La couche de Si contraint obtenue après recristallisation est alors inhomogène en termes d'orientation cristalline. Exemples de procédés de réalisation d'une couche de matériaux semi-conducteur contraint sont fournis par le documents US2005/0124146-A1 et EP2840594-A2.

Il se pose le problème de trouver un nouveau procédé de réalisation d'une structure dotée d'une couche de matériau semi-conducteur contraint qui soit amélioré vis-à-vis des inconvénients donnés ci-dessus.

### EXPOSÉ DE L'INVENTION

Un mode de réalisation de la présente invention prévoit un procédé de réalisation d'une structure comprenant une couche de matériau semi-conducteur contraint, le procédé comprenant des étapes de :
a) formation sur un substrat d'un empilement comprenant une première couche semi-conductrice à base d'un premier matériau semi-conducteur revêtue d'une deuxième couche semi-conductrice à base d'un deuxième matériau semi-conducteur de paramètre de maille différent de celui du premier matériau semi-conducteur,
b) réalisation sur la deuxième couche semi-conductrice d'un masque formé d'un ou plusieurs blocs,
c) implantations inclinées par rapport à une normale au plan principal du substrat, de sorte à rendre amorphe sur toute son épaisseur la première couche semi-conductrice ainsi que des zones de la deuxième couche semi-conductrice sans rendre amorphe une ou plusieurs régions de la deuxième couche semi-conductrice protégées par le masque et disposées respectivement en regard du ou des blocs du masque,
d) effectuer une recristallisation des régions rendues amorphes et de la première couche semi-conductrice rendues amorphes en se servant desdites régions de la deuxième couche semi-conductrice comme régions de départ des fronts de recristallisation d'où il résulte que cette première couche semi-conductrice est contrainte.

Le masque présente une symétrie par rapport à un plan de symétrie passant par au moins un premier bloc du masque, ce plan de symétrie étant orthogonal à un plan principal du substrat.

En prévoyant une répartition symétrique des blocs du masque, on incite une cristallisation sans rotation des germes cristallin, ce qui permet de mettre en oeuvre une couche semi-conductrice contrainte de structure cristalline plus homogène.

Le masque est avantageusement formé de plusieurs blocs identiques disposés dans le plan de symétrie selon un pas de répartition constant.

Cela permet de limiter les phénomènes de fluage de zones amorphes et participe ainsi à l'obtention d'un matériau semi-conducteur contraint de meilleure qualité.

Selon l'invention, on met en oeuvre des implantations inclinées par rapport à un plan parallèle à la normale au plan principal du substrat, ce plan étant lui-même un plan de symétrie du masque.

Les implantations inclinées sont de préférence symétriques par rapport à ce plan de symétrie, c'est à dire que des implantations sont réalisées de part et d'autre du plan de symétrie avec des valeurs respectives égales d'angles d'inclinaison. Les implantations symétriques réalisées de part et d'autre du plan de symétrie ont de préférence des énergies et doses respectives égales.

De même, la mise en oeuvre d'une telle symétrie participe à empêcher la rotation des germes cristallin.

Avantageusement, le premier bloc est disposé en regard d'une première région de la première couche semi-conductrice dans laquelle un canal de transistor est apte à être réalisé.

Le canal est ainsi réalisé dans une région éloignée des zones dans lesquelles les fronts de recristallisation sont susceptibles de se rencontrer à l'étape d).

La première couche semi-conductrice est de préférence rendue amorphe sur toute son épaisseur.

Selon un mode de réalisation particulier, le premier bloc peut avoir un motif semblable à celle d'une grille de transistor destinée à être réalisée en regard de la première région.

Le masque peut être formé par gravure d'au moins une couche à travers un masquage à base de copolymère à blocs.

Selon un mode de réalisation particulier, le masque à implantation comprend des blocs en forme de cylindres dont la base s'étend sur la deuxième couche semi-conductrice. Cela peut permettre d'avoir un masque dont les blocs ont un pas de répartition constant dans plusieurs directions.

Selon un autre mode de réalisation particulier, un ou plusieurs blocs du masque ont une forme de parallélépipède qui s'étend parallèlement au plan principal du substrat et orthogonalement au plan de symétrie. Une telle forme de masque peut permettre par amorphisation/recristallisation de mettre en oeuvre une première couche semi-conductrice en contrainte uni-axiale.

Le procédé peut comprenant en outre, après recristallisation, une étape de retrait de la deuxième couche semi-conductrice.

Après retrait de la deuxième couche semi-conductrice, le procédé peut comprendre la formation d'au moins un transistor dont la grille est disposée en regard de la première région et dont le canal s'étend entièrement dans la première région.

Avantageusement, la première couche semi-conductrice est en silicium, tandis que la deuxième couche semi-conductrice est en silicium germanium.

La deuxième couche semi-conductrice peut présenter un gradient de concentration en germanium, la concentration en Germanium diminuant au fur et à mesure que l'on se rapproche de la première couche.

On peut avantageusement prévoir une deuxième couche avec des concentrations en Germanium élevées, i.e. supérieure à 20% et en particulier comprise entre 20% et 50% au niveau de la face de la deuxième couche semi-conductrice ce qui peut permettre de contraindre davantage la première couche semi-conductrice lorsqu'elle est en silicium.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1F illustrent un exemple de procédé de réalisation d'une première couche semi-conductrice contrainte sur isolant dans lequel cette première couche est rendue amorphe puis recristallisée en lui imposant le paramètre de maille d'une deuxième couche semi-conductrice ;
- la figure 2 illustre une mise en oeuvre d'un transistor dont la région de canal s'étend dans la couche semi-conductrice contrainte et est prévue en dehors de zones dans lesquels des fronts de recristallisation se sont rencontrés lors de la recristallisation ;
- la figure 3 illustre un exemple de masque à implantation ayant un agencement symétrique et formé de blocs cylindriques aptes à protéger certaines régions de la deuxième couche semi-conductrice lors de l'amorphisation ;
- les figures 4A-4C illustrent un variante de procédé dans lequel le masque à implantation a une configuration propice la création d'une contrainte uni-axiale dans la première couche semi-conductrice ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes tels que « inférieure », « supérieure » qui dépendent de l'orientation de la structure s'appliquent en considérant que la structure est orientée de la façon illustrée dans les figures.

### EXPOSÉ DÉTAILLÉ DE MODES DE RÉALISATION PARTICULIERS

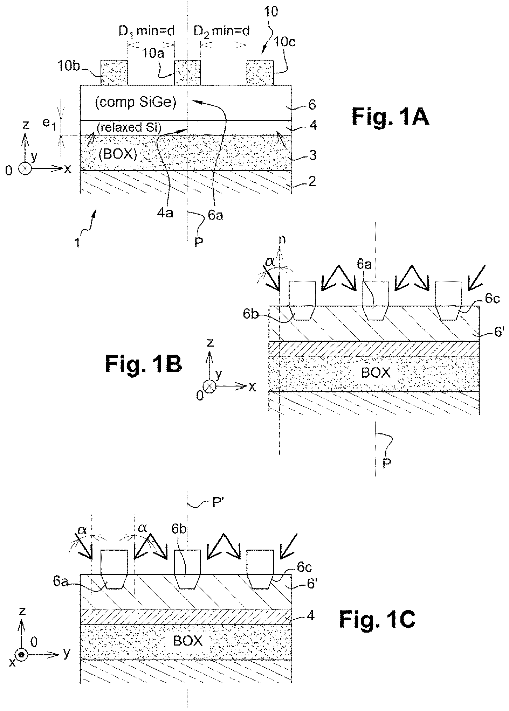

Un exemple de procédé de réalisation d'une structure dotée d'une couche de matériau semi-conducteur contraint, va à présent être donné en liaison avec les figures 1A-1F.

Le matériau de départ de ce procédé peut être un substrat 1 semi-conducteur sur isolant, en particulier un substrat SOI comprenant une couche 2 de support semi-conductrice par exemple en Si, revêtue d'une couche isolante 3 dite de BOX (pour « Burried Oxide »), elle-même revêtue d'une couche semi-conductrice 4 superficielle, par exemple à base de Si, destinée à être mise en contrainte, et que l'on appellera première couche semi-conductrice.

Sur la première couche semi-conductrice 4 on fait ensuite croitre par épitaxie une deuxième couche semi-conductrice 6 à base d'un matériau semi-conducteur ayant un paramètre de maille différent de celui du matériau de la première couche 4.

Lorsque la première couche semi-conductrice 4 est à base de silicium, la deuxième couche semi-conductrice 6 peut être prévue à base de silicium germanium (Si₁₋ₓGeₓ avec x par exemple compris entre 20 et 50 %). Dans ce cas, lors de la croissance épitaxiale, le silicium germanium a tendance à suivre le paramètre de maille du silicium d'où il résulte une couche de Si₁₋ₓGeₓcontrainte en compression.

De préférence, l'épaisseur e₁ de la première couche semi-conductrice 4 est choisie inférieure à une épaisseur critique de relaxation plastique. Cette épaisseur critique dépend notamment du niveau de contrainte de la deuxième couche semi-conductrice 6, ce niveau étant lui-même dépendant notamment de l'épaisseur e₂ de la deuxième couche semi-conductrice 6 et du paramètre de maille du matériau la constituant.

Lorsque la deuxième couche semi-conductrice 6 est à base de Si₁₋ₓGeₓ, l'épaisseur critique en dessous de laquelle l'épaisseur e₁ de la couche semi-conductrice 4 superficielle est choisie dépend de la concentration en Germanium de la deuxième couche semi-conductrice 6. Par exemple, on peut prévoir une première couche semi-conductrice 4 en silicium d'épaisseur e₁ inférieure à 10 nm lorsque la deuxième couche semi-conductrice 6 est en Si₁₋ₓGeₓ avec x de l'ordre de 0.20.

L'épaisseur e₂ de la deuxième couche semi-conductrice 6 peut être supérieure à e₁ et de préférence aussi élevée que possible tout en restant inférieure à une épaisseur critique de relaxation plastique hc telle qu'évoquée par exemple dans le document intitulé : « Critical thickness for plastic relaxation of SiGe » de Hartmann et al. Journal of Applied Physics 2011. Par exemple, lorsque la deuxième couche semi-conductrice 6 est en Si₁₋ₓGeₓ, son épaisseur peut être prévue de l'ordre de 20 nm.

La figure 1A représente une étape de formation d'un masque 10 à implantation sur la deuxième couche semi-conductrice 6.

Ce masque à implantation 10 est configuré pour protéger certaines régions de la deuxième couche semi-conductrice 6 lors d'une étape ultérieure d'implantation ionique. Le matériau et l'épaisseur du masque 10 à implantation sont adaptés en fonction des conditions d'implantation et en particulier de la dose, de l'énergie, de l'espèce envisagées pour cette implantation. Selon un exemple, on forme un masque 10 à implantation par gravure d'une couche de W d'épaisseur de l'ordre de 25 nm déposée sur une couche de 3nm de SiO₂. La couche dans laquelle le ou les blocs du masque 10 sont réalisés peut être gravée suivant un masque dur Al₂O₃ réalisée par dépôt de type ALD (pour « Atomic Layer Deposition ») au travers d'ouvertures d'un masquage à base de co-polymère à blocs. L'utilisation d'un tel masquage peut permettre notamment de réaliser un masque 10 à implantation dont les blocs ont une taille homogène et sont répartis de manière régulière sur la deuxième couche semi-conductrice 6.

Le masque 10 à implantation peut être formé de plusieurs blocs 10a, 10b, 10c, distincts avec une symétrie de répartition des blocs 10a, 10b, 10c par rapport à au moins un plan donné P, passant par la deuxième couche semi-conductrice 6 et par au moins un bloc de masquage, le plan P donné étant orthogonal à un plan principal du substrat 1. Par « plan principal » du substrat, on entend ici et dans toute la description un plan passant par le substrat et qui est parallèle au plan [O; x; y] du repère orthogonal [O; x; y; z] donné sur la figure 1A. Dans l'exemple de la figure 1A, le plan P de symétrie est un plan passant par un premier bloc 10a de masquage et séparant deux portions égales de ce premier bloc 10a.

Les blocs 10a, 10b, 10c formant le masque 10 sont répartis selon un pas constant dans au moins une direction parallèle au plan principal du substrat 1. Ainsi, dans l'exemple de la figure 1A, les blocs 10a, 10b, 10c sont agencés de sorte qu'une première distance minimale D1min entre le premier bloc 10a et le deuxième bloc 10b voisin du premier bloc 10a est égale à une distance minimale D2min entre le premier bloc 10a et le troisième bloc 10b voisin du premier bloc 10a, D1min, D2min étant égales à d, avec d qui peut être par exemple de l'ordre de 1 à 4 fois la longueur des blocs 10a, 10b, 10c, cette longueur étant mesurée parallèlement à l'axe y sur la figure 1A.

Selon un exemple de réalisation, les blocs 10a, 10b, 10c peuvent être prévus avec une longueur de l'ordre de 1 à 3 fois l'épaisseur e₂ de la deuxième couche semi-conductrice 6. Cette longueur est mesurée parallèlement à l'axe x sur la figure 1A.

Les blocs 10a, 10b, 10c peuvent être également formés avec une largeur égale ou sensiblement égale à leur longueur. La largeur des blocs est ici mesurée parallèlement à l'axe y sur la figure 1A.

Avantageusement, parmi les blocs 10a, 10b, 10c du masque 10 au moins un bloc 10a est disposé en regard d'une région 4a de la première couche semi-conductrice 4 dans laquelle une structure de canal de transistor est prévue.

Ensuite, on rend amorphe la première couche semi-conductrice 4 et certaines zones 6' de la couche semi-conductrice 6 qui ne sont pas protégées par le masque 10.

Pour cela, on effectue des implantations ioniques inclinées, c'est-à-dire telles que le faisceau d'ions réalise un angle α non-nul, encore appelé « tilt », avec une normale n au plan principal du substrat 1. Des régions 6a, 6b, 6c, de la couche semi-conductrice 6 disposées sous les blocs 10a, 10b, 10c du masque 10 et protégées par ce dernier ne sont quant à elles pas rendues amorphes.

De la forme des blocs 10a, 10b, 10c du masque 10 peut dépendre le nombre d'implantations effectuées. Dans un cas, par exemple, où les blocs 10a, 10b, 10c ont une largeur et une longueur égales on peut effectuer des implantations selon quatre quadrants différents, autrement dit selon quatre orientations différentes du faisceau d'ions.

La figure 1B illustre une réalisation d'au moins deux implantations inclinées et symétriques l'une de l'autre par rapport au plan P donné. Des implantations symétriques par rapport au plan P de symétrie sont réalisées de part et d'autre du plan de symétrie de préférence avec un même angle d'inclinaison et des énergies et doses respectives égales. La figure 1C illustre une mise en oeuvre d'au moins deux autres implantations inclinées et symétriques l'une de l'autre par rapport à un autre plan P'. Le plan P' est également un plan de symétrie du masque. Le plan P' est cette fois orthogonal au plan principal du substrat et au plan P donné. Dans l'exemple illustré sur les figures 1B, 1C, la première couche est rendue amorphe sur toute son épaisseur.

A titre d'exemple, dans un cas où la couche semi-conductrice 6 est une couche de 20 nm de Si₁₋ₓGeₓ avec x égal à 20 %, tandis que la première couche semi-conductrice 4 est en Silicium et a une épaisseur de 10 nm, et que le masque 10 en HfO₂ a une épaisseur de l'ordre de 10 nm, on peut réaliser l'étape d'amorphisation par le biais d'implantations de Si, selon un tilt de 20°, une dose comprise entre 1.5 et 3x10¹⁴ at/cm² une énergie comprise entre 20 et 30 keV.

Cette amorphisation permet d'obtenir une relaxation des régions 6a, 6b, 6c de la couche semi-conductrice 6. A l'issue de l'amorphisation, on obtient un agencement des régions 6a, 6b, 6c dont la structure cristalline a été conservée qui suit celui des blocs 10a, 10b, 10c du masque 10 à implantation.

On peut ensuite retirer le masque 10 à implantation. Par exemple, lorsque ce masque 10 est en W sur SiO₂, le retrait peut être réalisé à l'aide de peroxyde d'hydrogène (H₂O₂) puis d'acide fluorhydrique (HF).

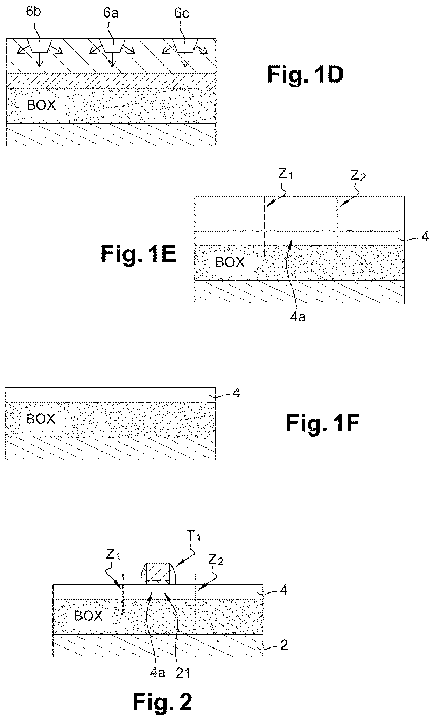

Puis, on effectue une recristallisation de la première couche semi-conductrice 4 et des zones 6' rendues amorphes de la couche superficielle 6, en se servant des régions 6a, 6b, 6c dont la structure cristalline a été conservée comme zones de départ de fronts de recristallisation. La figure 1D donne de manière schématique et par l'intermédiaire de flèches le sens de propagation des fronts de recristallisation.

La recristallisation est réalisée à l'aide d'au moins un recuit thermique. A titre d'exemple, dans un cas où la couche semi-conductrice 6 est une couche de 20 nm de Si₁₋ₓGeₓ avec x égal à 20 %, tandis que la première couche semi-conductrice 4 est en silicium et a une épaisseur de 10 nm, un recuit d'au moins 2 minutes à une température de l'ordre de 600°C peut être effectué.

Lors de la recristallisation, le matériau des régions 6a, 6b, 6c, par exemple du Si₁₋ₓGeₓ, impose son paramètre de maille à celui de la première couche semi-conductrice 4, qui est alors mis en contrainte. Lorsque la première couche semi-conductrice 4 est à base de Si on peut obtenir une couche 4 de silicium contraint sur isolant.

Du fait de l'agencement des régions 6a, 6b, 6c cristallines par rapport aux zones rendues amorphes, on limite d'éventuels phénomènes de rotation de germes cristallins ce qui permet d'obtenir, au final, un matériau semi-conducteur recristallisé de qualité améliorée et en particulier d'orientation cristalline plus uniforme.

La figure 1E représente l'empilement de couches semi-conductrices 4, 6 une fois la recristallisation effectuée. Sur cette figure, des lignes en traits discontinus Z1, Z2 correspondent à des zones de rencontre des fronts de recristallisation.

Une région 4a de la première couche semi-conductrice 4 dans laquelle une région de canal de transistor est prévue est ainsi éloignée autant que possible des zones de rencontre de fronts de recristallisation, ce qui peut permettre de mettre en oeuvre un transistor aux performances électriques améliorées.

Ensuite, on retire la deuxième couche semi-conductrice 6. Ce retrait peut être effectué par gravure sélective vis-à-vis du matériau de la première couche semi-conductrice 4.

A titre d'exemple, la gravure sélective de la deuxième couche semi-conductrice 6 lorsqu'elle est en Si₁₋ₓGeₓ et disposée sur une couche 4 de Si, peut être réalisée à l'aide d'un mélange d'acide acétique, de peroxyde d'hydrogène, et d'acide fluorhydrique.

A l'issue de ce retrait, on obtient un substrat de type semi-conducteur contraint sur isolant tel qu'illustré sur la figure 1F et à partir duquel un dispositif microélectronique peut être réalisé.

La figure 2 représente une structure de transistor T doté d'une structure de canal prévue dans la région 4a de la première couche semi-conductrice 4 qui est la plus éloignée des zones Z1, Z2 de rencontre des fronts de recristallisation.

Une variante de l'exemple de réalisation précédemment décrit prévoit de réaliser un masque 100 à implantation formé cette fois de blocs 100a, 100b, 100c ayant une forme de cylindre dont une base s'étend parallèlement au plan principal du substrat 1.

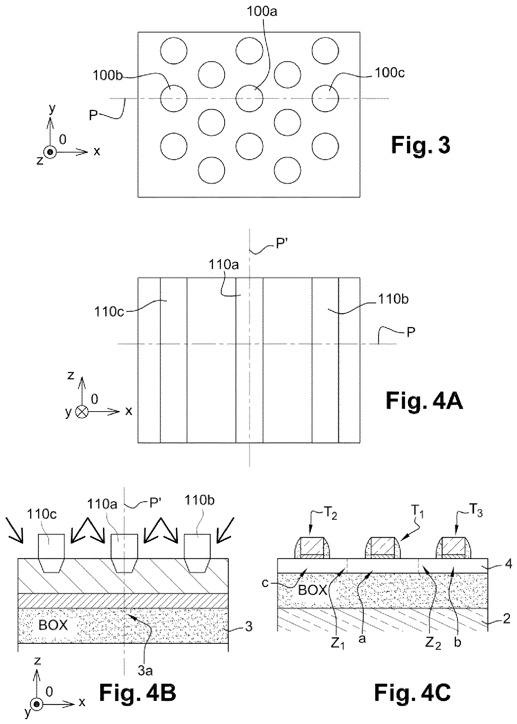

Un tel masque 100 est représenté sur la figure 3 en vue de dessus.

Le masque 100 a également un agencement symétrique si l'on considère un plan P de symétrie orthogonal au plan principal du substrat et passant par au moins un bloc 100a. Ce masque 100 peut être formé par dépôt d'une couche au travers d'un masquage en un matériau copolymère à blocs. Un tel matériau est apte à s'auto-organiser en un réseau hexagonal plan de cylindres de section sensiblement circulaire ou polygonale dans une matrice. Un tel matériau permet d'obtenir une bonne homogénéité des motifs du masquage et une répartition selon un pas constant. Le matériau du masquage peut être en particulier un copolymère di-blocs dont un des polymères forme les cylindres et dont l'autre polymère forme une matrice. Le matériau copolymère di-blocs peut être par exemple l'un parmi : le PS-PMMA (pour polystyrène-poly(méthacrylate de méthyle)), le PS-PVP (pour polystyrène-polyvinylpyrrolidone), le PS-PEO (pour « polystyrène-oxyde de polyéthylène). L'étape de formation des motifs du masquage comprend l'élimination sélective des cylindres par rapport à la matrice. Dans un cas, par exemple, où les cylindres sont à base de PMMA dans une matrice de PS, le retrait peut être réalisé par un procédé comprenant une immersion dans un bain d'acide acétique pendant une durée de plusieurs minutes, puis une exposition à un plasma d'argon et d'oxygène. Le masque 100 a dans cet exemple également un agencement symétrique si l'on considère un autre plan P' de symétrie orthogonal au plan principal du substrat et orthogonal au plan P.

Avec un tel masque, on peut réaliser des implantations symétriques et inclinées d'amorphisation par rapport au plan P ou au plan P'.

Une autre variante de l'exemple de réalisation précédemment décrit est illustrée sur les figures 4A-4C. On réalise cette fois un masque 110 à implantation comprenant des blocs 110a, 110b, 110c en forme de parallélépipèdes qui s'étendent dans le sens de leur longueur, parallèlement au plan principal du substrat 1.

Un tel masque 110 est représenté sur la figure 4A en vue de dessus. Le masque 110 a blocs parallélépipédiques a également un agencement symétrique par rapport à un plan P de symétrie orthogonal au plan principal du substrat et passant par les blocs 110a, 110b, 110c. Les blocs 110a, 110b, 110c du masque sont disposés en regard de régions 4a, 4b, 4c de la première couche semi-conductrice 4 prévues pour accueillir respectivement des régions de canal de transistors. Avantageusement, ces blocs 110a, 110b, 110c ont un motif semblable à celui prévu pour des grilles 41, 42, 43 de transistors T₁, T₂, T₃ destinées à être réalisées sur les régions 4a, 4b, 4c de la première couche semi-conductrice 4.

Ainsi, dans cet exemple, un bloc 110a du masque s'étend en regard de l'ensemble de la région 4a dans laquelle le canal du transistor T₁ est prévue.

On effectue ensuite des implantations ioniques inclinées afin de réaliser l'amorphisation de la première couche 4 et de zones 6' de la deuxième couche. Dans cet exemple, l'amorphisation peut être effectuée à l'aide d'implantations réalisées sur deux quadrants différents, autrement dit, comme cela est illustré sur la figure 4B, à l'aide d'au moins deux implantations inclinées et symétriques l'une de l'autre par rapport à un plan P'. Ce plan P' est orthogonal au plan principal du substrat ainsi qu'au plan P de symétrie du masque 110.

Après cette amorphisation, on effectue les étapes de recristallisation de sorte à contraindre la première couche semi-conductrice 4. De par l'agencement du masque 110 et la forme de ces blocs 110a, 110b, 110c, on peut, à l'issue de la recristallisation, obtenir une première couche semi-conductrice 4 en contrainte uni-axiale dans une direction parallèle au plan principal du substrat et orthogonale à celle dans laquelle les blocs 110a, 110b, 110c du masque 110 s'étendent.

Des étapes de retrait du masque 110, de retrait de la deuxième couche semi-conductrice 6 sont également mises en oeuvre.

La figure 4C illustre la réalisation ultérieure de transistors T₁, T₂, T₃ sur des régions 4a, 4b, 4c de la première couche semi-conductrice 4 en regard desquelles les blocs 100a, 100b, 100c du masque étaient disposés. L'agencement des régions 4a, 4b, 4c de canal respectives des transistors T₁, T₂, T₃ est prévu en dehors des zones de rencontre des fronts de recristallisation symbolisées par les lignes Z1, Z2, ces zones étant dans cet exemple situées au niveau des blocs de source et de drain. On évite ainsi de détériorer les performances des canaux des transistors T₁, T₂, T₃.

En variante de l'un ou l'autre des exemples de procédés précédemment décrits, on peut prévoir de réaliser le masque 10 à implantation en un matériau contraint, tel que du nitrure de Silicium contraint en tension et ce afin d'augmenter la contrainte transférée lors de la recristallisation des zones 6' et de la première couche semi-conductrice 4.

Selon une autre variante de réalisation de l'un ou l'autre des exemples décrits précédemment, on forme une deuxième couche en Si_{1-y}Ge_{y} avec y variant par exemple entre y=0.20 au niveau de sa face inférieure, et y=0.50 au niveau de sa face supérieure. Par face « inférieure » on entend celle en contact avec la première couche semi-conductrice 4, tandis que la face dite « supérieure » est opposée à la face inférieure.

La deuxième couche en Si_{1-y}Ge_{y} a donc un gradient de concentration en Germanium avec une concentration en Germanium qui augmente lorsque l'on s'éloigne de la première couche semi-conductrice. Cela peut permettre de conserver des régions cristallines ayant une concentration Germanium élevée sous les blocs du masque 10 à la suite de l'étape d'amorphisation. On peut alors effectuer une recristallisation en se servant de germes cristallins ayant une concentration en Germanium élevée afin d'obtenir une contrainte accrue dans la première couche semi-conductrice 4.

Un procédé suivant l'invention peut s'appliquer à d'autres couples de matériaux que le silicium et le silicium germanium. Un empilement différent de couches semi-conductrices 4 et 6 peut être prévu. Par exemple, on peut mettre une première couche semi-conductrice 4 contrainte en Germanium en faisant cette fois croitre par épitaxie une deuxième couche semi-conductrice 6 en un matériau à paramètre de maille supérieur tel que par exemple du GeₓSn₁₋ₓ. Selon un autre exemple, une première couche semi-conductrice 4 en In_{y}Ga_{1-y}As contraint peut être réalisée en faisant croitre une deuxième couche semi-conductrice 6 en In_{z}Al_{1-z}As (avec z>y).

## Revendications

1. Procédé de réalisation d'une structure comprenant une couche de matériau semi-conducteur contraint, le procédé comprenant des étapes consistant à :
a) prévoir sur un substrat (1) un empilement comprenant une première couche semi-conductrice (4) à base d'un premier matériau semi-conducteur revêtu d'une deuxième couche semi-conductrice (6) à base d'un deuxième matériau semi-conducteur de paramètre de maille différent de celui du premier matériau semi-conducteur,
b) réaliser sur la deuxième couche semi-conductrice un masque (10) formé d'un ou plusieurs blocs (10a, 10b, 10c, 100a, 100b, 100c, 110a, 110b, 110c), le masque étant symétrique par rapport à un plan (P) de symétrie passant par au moins un premier bloc (10a, 100a, 110a) du masque (10), ce plan étant orthogonal à un plan principal du substrat,
c) effectuer une ou plusieurs implantations inclinées par rapport à une normale au plan principal du substrat, de sorte à rendre amorphe la première couche semi-conductrice (4) sur toute son épaisseur ainsi que des zones (6') de la deuxième couche semi-conductrice (6) sans rendre amorphe une ou plusieurs régions (6a, 6b, 6c) de la deuxième couche semi-conductrice protégées par le masque et disposées respectivement en regard du ou des blocs de masque,
d) effectuer une recristallisation des zones (6') de la deuxième couche semi-conductrice (6) et de la première couche semi-conductrice rendues amorphes (6a, 6b, 6c) en se servant desdites régions (6a, 6b, 6c) de la deuxième couche semi-conductrice comme régions de départ de fronts de recristallisation d'où il résulte que cette première couche semi-conductrice est contrainte.

2. Procédé selon la revendication 1, dans lequel le ou les premiers blocs (10a) sont disposés en regard d'une première région (4a) de la première couche semi-conductrice (4) dans laquelle un canal de transistor (T₁) est apte à être réalisé.

3. Procédé selon la revendication 2, dans lequel le premier bloc (10a) est un motif de grille de transistor.

4. Procédé selon l'une des revendications 1 à 3, dans lequel le masque (10) est formé de plusieurs blocs identiques (10a, 10b, 10c, 100a, 100b, 100c, 110a, 110b, 110c) disposés dans le plan (P) de symétrie selon un pas de répartition constant.

5. Procédé selon la revendication 4, dans le masque (10) est formé par dépôt d'au moins une couche à travers un masquage à base de copolymère à blocs.

6. Procédé selon l'une des revendications 1 à 5, dans lequel au moins un bloc (110a, 110b, 110c) du masque (10) a une forme de cylindre dont une base s'étend sur la deuxième couche semi-conductrice (6).

7. Procédé selon l'une des revendications 1 à 6, dans lequel un ou plusieurs blocs (110a, 110b, 110c) du masque (10) ont une forme de parallélépipède qui s'étend parallèlement au plan principal du substrat et orthogonalement au plan (P) de symétrie.

8. Procédé selon l'une des revendications 1 à 7, comprenant en outre après l'étape de recristallisation : une étape de retrait de la deuxième couche semi-conductrice (6).

9. Procédé selon la revendications 8, comprenant en outre, après l'étape de retrait de la deuxième couche semi-conductrice (6), la formation d'un transistor (T) dont la grille est disposée en regard de la première région (4a) et dont le canal s'étend entièrement dans la première région.

10. Procédé selon l'une des revendications 1 à 9, dans lequel la première couche semi-conductrice (3) est en silicium, la deuxième couche semi-conductrice (6) est en silicium germanium.

11. Procédé selon la revendication 10, dans lequel la deuxième couche semi-conductrice (6) présente un gradient de concentration en germanium.

12. Procédé de formation d'un transistor comprenant la mise en oeuvre d'un procédé selon l'une des revendications 1 à 11.

## Patentansprüche

1. Verfahren zur Herstellung einer Struktur, umfassend eine Schicht aus verspanntem Halbleitermaterial, wobei das Verfahren die folgenden Schritte umfasst:
a) Bereitstellen, auf einem Substrat (1), eines Stapels, umfassend eine erste Halbleiterschicht (4) auf Basis eines ersten Halbleitermaterials, beschichtet mit einer zweiten Halbleiterschicht (6) auf Basis eines zweiten Halbleitermaterials mit einem Gitterparameter, der von jenem des ersten Halbleitermaterials verschieden ist,
b) Herstellen, auf der zweiten Halbleiterschicht, einer Maske (10), die aus einem oder mehreren Blöcken (10a, 10b, 10c, 100a, 100b, 100c, 110a, 110b, 110c) gebildet ist, wobei die Maske bezüglich einer Symmetrieebene (P) symmetrisch ist, die durch wenigstens einen ersten Block (10a, 100a, 110a) der Maske (10) verläuft, wobei diese Ebene orthogonal zu einer Hauptebene des Substrats ist,
c) Durchführen von einer oder mehreren Implantationen, die bezüglich einer Normalen zu der Hauptebene des Substrats schräg sind, derart, dass die erste Halbleiterschicht (4) auf ihrer gesamten Dicke sowie Zonen (6') der zweiten Halbleiterschicht (6) amorph gemacht werden, ohne eine oder mehrere Regionen (6a, 6b, 6c) der zweiten Halbleiterschicht amorph zu machen, die durch die Maske geschützt sind und jeweils gegenüber des Blocks oder der Blöcke der Maske angeordnet sind,
d) Durchführen einer Rekristallisation der Zonen (6') der zweiten Halbleiterschicht (6) und der ersten Halbleiterschicht, die amorph gemacht sind (6a, 6b, 6c) indem man sich der Regionen (6a, 6b, 6c) der zweiten Halbleiterschicht bedient als Ausgangsregionen von Rekristallisationsfronten, was dazu führt, dass diese erste Halbleiterschicht verspannt wird.

2. Verfahren nach Anspruch 1, bei dem der oder die ersten Blöcke (10a) gegenüber einer ersten Region (4a) der ersten Halbleiterschicht (4) angeordnet sind, in der ein Transistorkanal (T₁) hergestellt werden kann.

3. Verfahren nach Anspruch 2, bei dem der erste Block (10a) ein Motiv eines Gate des Transistors ist.

4. Verfahren nach einem der Ansprüche 1 bis 3, bei dem die Maske (10) aus mehreren identischen Blöcken (10a, 10b, 10c, 100a, 100b, 100c, 110a, 110b, 110c) gebildet ist, die in der Symmetrieebene (P) gemäß einem konstanten Verteilungsabstand angeordnet sind.

5. Verfahren nach Anspruch 4, bei dem die Maske (10) durch Aufbringen wenigstens einer Schicht durch eine Maskierung auf Basis von Blockkopolymeren hindurch gebildet ist.

6. Verfahren nach einem der Ansprüche 1 bis 5, bei dem wenigstens ein Block (110a, 110b, 110c) der Maske (10) die Form eines Zylinders hat, von dem sich eine Basis auf der zweiten Halbleiterschicht (6) erstreckt.

7. Verfahren nach einem der Ansprüche 1 bis 6, bei dem ein oder mehrere Blöcke (110a, 110b, 110c) der Maske (10) die Form eines Parallelepipeds hat/haben, das sich parallel zur Hauptebene des Substrats und orthogonal zur Symmetrieebene (P) erstreckt.

8. Verfahren nach einem der Ansprüche 1 bis 7, ferner umfassend nach dem Schritt der Rekristallisation einen Schritt des Entfernens der zweiten Halbleiterschicht (6).

9. Verfahren nach Anspruch 8, ferner umfassend nach dem Schritt des Entfernens der zweiten Halbleiterschicht (6) die Bildung eines Transistors (T), dessen Gate gegenüber der ersten Region (4a) angeordnet ist, und dessen Kanal sich vollständig in der ersten Region erstreckt.

10. Verfahren nach einem der Ansprüche 1 bis 9, bei dem die erste Halbleiterschicht (3) aus Silizium ist, wobei die zweite Halbleiterschicht (6) aus Silizium-Germanium ist.

11. Verfahren nach Anspruch 10, bei dem die zweite Halbleiterschicht (6) einen Konzentrationsgradienten des Germanium aufweist.

12. Verfahren zur Herstellung eines Transistors, umfassend die Durchführung eines Verfahrens nach einem der Ansprüche 1 bis 11.

## Claims

1. A method for producing a structure comprising a layer of strained semiconductor material, the method comprising steps consisting of:
a) providing on a substrate (1) a stack comprising a first semiconductor layer (4) based on a first semiconductor material coated with a second semiconductor layer (6) based on a second semiconductor material having a different lattice parameter to that of the first semiconductor material,
b) producing on the second semiconductor layer a mask (10) formed by one or a plurality of separate blocks (10a, 10b, 10c, 100a, 100b, 100c, 110a, 110b, 110c) the mask being symmetrical with respect to a plane (P) of symmetry, this plane of symmetry being orthogonal to a main plane of the substrate and passing through at least one first block (10a, 100a, 110a) of the mask,
c) performing one or a plurality of inclined implantations with respect to a normal to the main plane of the substrate, so as to render amorphous the first semiconductor layer (4) over its entire thickness and the zones (6') of the second semiconductor layer (6) without rendering amorphous one or a plurality of regions (6a, 6b, 6c) of the second semiconductor layer protected by the mask and arranged respectively opposite the mask block(s),
d) performing recrystallisation of the zones (6') of the second amorphous semiconductor layer (6) and of first semiconductor amorphous layer (6a, 6b, 6c) using said regions (6a, 6b, 6c) of the second semiconductor layer as starting regions of recrystallization fronts from which it follows that this first semiconductor layer is strained.

2. The method according to claim 1, wherein the first block (10a) of the mask is arranged facing a first region (4a) of the first semiconductor layer (4) wherein a transistor (T₁) channel is to be formed.

3. The method according to claim 2, wherein the first block (10a) is a transistor gate pattern.

4. The method according to any of the claims 1 to 3, wherein the mask (10) is formed from a plurality of identical blocks (10a, 10b, 10c, 100a, 100b, 100c, 110a, 110b, 110c) arranged in the plane (P) of symmetry according to a constant distribution interval.

5. The method according to claim 4, wherein the mask (10) is formed by depositing at least one layer via block copolymer-based masking.

6. The method according to any of the claims 1 to 5, wherein at least one block (110a, 110b, 110c) of the mask (10) has a cylinder shape wherein a base extends along the second semiconductor layer (6).

7. The method according to any of the claims 1 to 6, wherein one or a plurality of the blocks (110a, 110b, 110c) of the mask (10) have a parallelepiped shape extending parallel with the main plane (P) of the substrate and orthogonally to the plane of symmetry.

8. The method according to any of the claims 1 to 7, further comprising after the recrystallisation step: a step for removing the second semiconductor layer (6).

9. The method according to claim 8, further comprising, after the step for removing the second semiconductor layer (6), the formation of a transistor (T) wherein the gate is arranged facing the first region (4a) and wherein the channel extends entirely in the first region.

10. The method according to any of the claims 1 to 9, wherein the first semiconductor layer (3) is made of silicon, the second semiconductor layer (6) is made of silicon-germanium.

11. The method according to claim 10, wherein the second semiconductor layer (6) has a germanium concentration gradient.

12. The method for forming a transistor comprising the use of a method according to any of the claims 1 to 11.
